(19) Europäisches Patentamt

European Patent Office

Office européen des brevets

(11) **EP 0 680 523 B1**

(12) **EUROPEAN PATENT SPECIFICATION**

(45) Date of publication and mention
of the grant of the patent:
**09.02.2000 Bulletin 2000/06**

(21) Application number: **95900029.0**

(22) Date of filing: **18.11.1994**

(51) Int. Cl.[7]: **C23C 18/18**, C04B 41/53

(86) International application number:
**PCT/BR94/00039**

(87) International publication number:
**WO 95/14116 (26.05.1995 Gazette 1995/22)**

(54) **PREPARATION OF ALUMINA CERAMIC SURFACES FOR ELECTROLESS AND ELECTROCHEMICAL METAL DEPOSITION**

VORBEHANDLUNG VON KERAMISCHEN ALUMINIUMOXIDOBERFLÄCHEN ZUR STROMLOSEN UND ELEKTROCHEMISCHEN METALLPLATTIERUNG

PREPARATION DE SURFACES EN CERAMIQUE D'ALUMINE EN VUE D'UN DEPOT CHIMIQUE ET ELECTROCHIMIQUE DE METAUX

(84) Designated Contracting States:
**BE CH DE ES FR GB IT LI NL**

(30) Priority: **19.11.1993 BR 9304546**

(43) Date of publication of application:
**08.11.1995 Bulletin 1995/45**

(73) Proprietor:
**Telecomunicaçòes Brasileiras s/a - Telebrás
13088-061 Campinas - SP (BR)**

(72) Inventors:
• **FLACKER, Alexander
Campinas, SP (BR)**

• **GOZZI, Antonio Cesar
Av. Nossa Senhora De Fátima,
Campinas, SP (BR)**
• **RAUTEMBERG FINARDI, Márcia
Campinas, SP (BR)**
• **FISSORE, Alfeu
Campinas, SP (BR)**

(74) Representative:
**Ayers, Martyn Lewis Stanley
J.A. KEMP & CO.
14 South Square
Gray's Inn
London WC1R 5LX (GB)**

(56) References cited:
**WO-A-88/02412        US-A- 4 867 843**

EP 0 680 523 B1

**Description**

The present invention relates to the coating of ceramic surfaces and, more particularly, to the chemical and electrochemical plating of 96% alumina ceramic substrates with metallic layers, through the use of acqueous solutions.

Ceramic materials are widely employed en electrical and electronic equipments, by virtue of their excellent chemical, thermal and electrical properties. In most applications, such as packaging for integrated circuitry, multichip modules and the like, it is necessary to provide current paths, strips or surfaces, that must have a low electrical resistance as well as good solderability

The plating of ceramic surfaces with metals is well known in the art, being described in several papers and patents, some of which are mentioned below:

1 - Shrivastava P.B.; Venkatramani N.; et al. Electroless Nickel Deposition on Ceramic and Copper Surfaces, *Metal Finishing*, Feb. 1985

2- Baudrand D.W. Cleaning and Preparation of Ceramic and Metallized Ceramic Materials for Plating, *Plating and Surface Finishing*, Oct. 1984

3-Honma H.; Kanemitsu K. Electroless Nickel Plating on Alumina Ceramics, *Plating and Surface Finishing*, Sep. 1987

4- Tsuru Y.; Okamura T.; et al. Process for Forming Metallic Film on Inorganic Material, US Patent 4842899.

The usual plating processes comprise the sequential deposition of several metallic layers on the ceramic substrate, the first of these layers being deposited by a self-catalytic or electroless reaction, and the following layers being applied by well-known electroplating processes. According to the aforementioned references, the ceramic surface metallisation processes share the following common steps:

a - initial cleaning for grease removal, with an acqueous solution of an alkali or a detergent;

b - surface treatment of the ceramic with an etchant such as an organic acid or a molten alkali to remove vitreous material from the outermost layer of the substrate;

c - sensitisation and activation of the ceramic surface by dipping the substrate in a stannous chloride solution, followed by immersion in a solution of palladium chloride;

d - electroless plating with a layer of nickel-phosphorus, nickel-boron or copper, through reduction from the ionic form in acqueous solution to the metallic form calysed by the palladium adsorbed on the ceramic surface;

e - electroplating a layer of low-resistance metal, such as copper, over the first electroless layer, followed optionally by plating one or more additional metallic layers to provide protection against oxidation as well as good solderability.

Between each step and the following, the ceramic substrate is rinsed in deionised or distilled water.

The known processes summarised in the aforementioned sequence, suffer from shortcomings such as, in one instance, insufficient bonding of the metal to the substrate, or the development of blisters when subjected to high temperatures. This has been found to happen when step (b) is carried out according to the technique described by Baudrand, i.e., when the ceramic surface is etched with a 10% HF solution. As a matter of fact, figure 2 of Honma & Kanemitsu's paper, plotting bonding strengths for different etching solutions, shows that, of all the etchants normally employed, the hydrofluoric acid solution yields the poorest results.

However, practical experiments and tests carried out in accordance with the above mentioned paper did not either yield acceptable results, showing blister development when the metallised ceramic substrates were heated. Other experiments, carried out in accordance with other documents, also yielded results which fell short of expectations, mainly regarding the long term bonding strength of the metal layers.

One of the reasons for the aforementioned problems can be ascribed to an insufficient preparation of the ceramic surface before the sensitisation stage; in other words, the known processes do not render the surface totally adequate for the chemical deposition, impairing the adhesion of the metallic coating.

In view of the above, it is the main object of the invention to provide a plating process on 96% alumina ceramic surfaces that ensures the formation of metallic layers with optimum bonding characteristics, free from blisters and showing good solderability as well as low electrical resistance.

A further object of the invention is to provide a process that uses low cost and commercially available materials.

To this effect, according to the invention, additional surface cleaning steps are provided, before and after the removal of vitreous material, with the purpose of thoroughly freeing the ceramic surface from other impurities such as magnesium, calcium and the like.

More specifically, according to the invention's principles, the surface preparation comprises the following steps:

• a first cleansing step of the alumina ceramic substrates surface;

- an etching step for removal of vitreous material from said ceramic substrates surface;
- a second cleansing step of said substrates surface;
- sensitisation followed by activation of said substrates surface by means of immersion in aqueous solutions of stannous chloride and palladium chloride,

wherein said first surface cleansing step comprises immersion of said substrates in a mixture of sulfuric acid and hydrogen peroxide, said etching step for removal of vitreous material step comprises immersion of said substrates in an acqueous solution of ammonium fluoride and sodium chloride, and said second cleansing step comprises immersion of said substrates in a mixture of sulfuric acid and hydrogen peroxide.

According to a further feature of the invention, the mixture employed in said first and second surface cleansing steps comprise 1 to 4 parts sulfuric acid to 1 part hydrogen peroxide, heated to roughly 100 degrees Celsius.

According to a still further feature of the invention, the etching solution for the vitreous removal step comprises a solution of ammonium fluoride and sodium chloride, the amount of either substance ranging from 20 to 100 grams / liter, the temperature being between 50 and 80 degrees Celsius.

After rinsing in deionised water with $\rho \approx 3$ M$\Omega$cm, the alumina surface is sensitised and activated. Sensitisation is accomplished by immersing the substrates in a solution comprising 0,3 to 1 gram / liter stannous chloride and 2 to 10 ml / liter hydrochloric acid.

Following the sensitisation dip, the alumina substrates are rinsed in deionised water ($\rho \approx 3$ M$\Omega$cm), and activated by immersion in the activation bath, comprising the following aqueous solutions:

| palladium chloride | 0.2 to 0.4 gram / liter |
|---|---|
| hydrochloric acid | 2 to 4 ml/ liter |

After another rinse in deionised water, the substrates are dipped for a short time in the accelerator; in the present case, an acid solution is used such as an aqueous solution of 1% to 3% hydrochloric acid, this step being followed again by a rinse in deionised water.

The next stage consists of the electroless plating of the 96% alumina ceramic substrate, with either nickel-boron or nickel-phosphorus. Although being well-known in the art, it must be stressed that this step must be carried out very carefully, for the adhesion of additional metallic layers depends on a good bond between the electrolessly deposited metal and the ceramic surface.

When the first layer is Ni-B, the most probable nickel deposition reaction is the following:

$$3Ni^{++} + 2(CH_3)_2 NHBH_3 + 6H_2O \xrightarrow{Pd^o} 3Ni^o + 2(CH_3)_2NH^+ + +2H_3BO_3 + H^+ - 3H\uparrow \tag{I}$$

Simultaneously, the co-deposition of boron takes place according to the reaction below:

$$B(OH)_4^- + 3e \xrightarrow{Pd^o} B + 4OH^- \tag{II}$$

For the Ni-B deposition, the electroless bath comprises a mixture of the following solutions, in various proportions:

| nickel chloride | 11.5 to 13.5 gram / liter |
|---|---|
| disodium tartrate | 46.2 to 48.2 gram / liter |
| dimethyl amine borane | 1.4 to 2.0 gram / liter |

When the above mentioned bath is employed, care must be taken not to exceed 30 seconds immersion, to avoid undue stress in the electrolessly deposited layer of Ni-B.

For the electroless deposition of the nickel-phophorus layer a mixture of the following solutions is used:

| hexahydrated nickel sulfate | 26 grams / liter |
|---|---|
| dihydrated trisodium citrate | 30 grams / liter |
| hydrated sodium hypophosphide | 17 grams / liter |
| ammonium sulphate | 66 grams / liter |

The following simplified equation depicts the electroless nickel deposition reaction:

$$Ni^{++} + (H_2PO_2)^- + H_2O \xrightarrow{Pd^o} Ni^o + 2H^+ + H(HPO_3)^- \qquad (III),$$

the phosphorus being co-deposited with the nickel according to the hypophosphide reduction reaction shown below:

$$(H_2PO_2)^- + H \xrightarrow{Pd^o} H_2O + OH^- + P^o \qquad (IV)$$

Normally, about 5% phosphorus will be incorporated to the nickel film when the pH of the mixture is kept at a value around 9, as described by Georgiou, Bechtold, et al., in the article *Selective Electroless Plated Ni Contacts to CMOS Junctions with CoSi_2*, published in the Journal of the Electrochemical Society, v. 138 nº 12, Dec. 1991.

The bath temperature is 90°C and the immersion time varies from 30 seconds to 1 minute. At the end of the electroless plating period, the substrates are withdrawn from the plating bath (either Ni-B or Ni-P) and immediately rinsed in deionised water.

Following this rinse, the substrates are placed in a container filled with distilled or deionised water and subjected to a few minutes of ultrasound. This ultrasound treatment eliminates the small flakes formed in the electroless layer surface, therefore avoiding the growth of bumps in the electroplated layers which could impair the production, by photoengraving techniques, of narrow conducting strips having a width of 50 μm (microns) or less.

Considering that the invention aims to provide the firm bonding of a high conductivity metal film to the ceramic substrate, it is obvious that the electroless layer must be coated with a layer of electroplated low resistivity material, such as copper.

In cases where nickel-boron is used in the electroless layer, the incompatibility between boron and copper could impair the bonding strength of the electroplated copper layer;a shortcoming that is avoided by electroplating a nickel layer between the Ni-B and Cu layers, ranging in thickness from 0.5 μm to 2.5 μm. Although this will add an extra processing step, several practical advantages derive from the adoption of nickel-boron for the electroless layer, such as an easier etching than Ni-P alloys when standard copper etchants, such as cupric chloride, are used for the fabrication of printed circuits (see US Patent 4,832,799).

The remaining steps of the metallisation process are carried out by conventional techniques; optionally, an uppermost layer of gold, not less than 1 μm thick, can be electroplated to provide good solderability and protection against oxidation.

The following examples illustrate the present invention and are not intended to limit the same.

EXAMPLE 1

Several platelike specimens measuring 2.54 cm by 2.54 cm (1" by 1") by 635 μm (0.025") thick of alpha-type 96% alumina ceramic substrates (Coors), having a surface roughness between 0.25 and 0.34 μm, were processed according to the following sequence:

1. 5 minutes at 100°C in a mixture composed of 2 parts sulfuric acid to 1 part hydrogen peroxide, to remove impurities, followed by a 15 minutes rinse in running deionised water. For this operation, as well as for all other rinsing stages, deionised water having $\rho \approx 3M\Omega cm$ was used.

2. 15 minutes at 60°C in aqueous solution of 50 grams sodium chloride and 50 grams ammonium fluoride per liter, continuously stirred, for removing vitreous material from the ceramic surface, followed by 15 minutes rinse in running deionised water.

3. 5 minutes at 100°C in a mixture composed of 2 parts sulfuric acid to 1 part hydrogen peroxide, to remove any residues left by the previous operation, as well as calcium, magnesium and other impurities, followed by subjecting the substrates to ultrasound treatment, for 5 minutes, immersed in the same mixture as above. The substrates were then rinsed for 15 minutes in running deionised water and subjected to 5 minutes ultrasound, immersed in deionised water, withdrawn and kept immersed in distilled water until the sensitisation stage.

4. 2 minutes at ambient temperature in a sensitising aqueous solution comprising 0.5 g / l stannous chloride and 4 ml / l concentrated hydrochloric acid, continuously stirred, removed and rinsed for 10 seconds in running deionised water and immersed for 1 minute in the activating aqueous solution comprising 0.25 g / l palladium chloride and 2.5 ml / l hydrochloric acid. After a 10 seconds rinse in running deionised water, the sensitisation and activation steps were repeated, followed by a 5 seconds dip in 1% solution of hydrochloric acid, and again rinsed in deionised water.

5. 15 to 20 seconds immersion in the electroless Ni-B plating bath at 70°C, comprising the following aqueous solutions:

7 parts nickel chloride @ 12.5 g / l
7 parts dimethyl amine borane @ 1.6 g / l
1 part disodium tartrate @ 47.2 g / l

followed by a 5 to 10 seconds rinse in deionised water.

6. Placing the substrates in a container filled with distilled water and subjecting to 2 minutes ultrasound treatment.

7. Electroplating a nickel layer to 1.5 μm, in an aqueous bath sold under the tradename Nickel Deweka 720, available from Orwec Química S.A., magnetically stirred at a temperature of 45°C, the current density being 2 A/dm$^2$ (amps per square decimeter), and the pH $\approx$ 3.5. The substrates were then rinsed for 1 minute in running deionised water.

8. Electroplating to a thickness of 2.5 μm with acid copper bath, using a commercially available bath, overlaid by an electroplated nickel layer 1.5 μm thick, deposited through the same technique as described in step 7.

9. Finally, a 1 μm layer of gold was electroplated over the nickel, using a known process.

The bonding strength between the metallic coating and the ceramic surface was performed with the Sebasthian Adherence Tester. A metallic post having a circular flat face 2.4 mm in diameter was attached to the metal surface of each of 12 samples with Araldite AV8. Traction force was applied normal to the surface, yelding the results listed below:

| | | |
|---|---|---|
| Sample # 1 | 22.06 MPa | (225 kgf / cm$^2$) |
| Sample # 2 | 23.63 MPa | (241 kgf / cm$^2$) |
| Sample # 3 | 14.51 MPa | (148 kgf / cm$^2$) |
| Sample # 4 | 24.52 MPa | (250 kgf / cm$^2$) |
| Sample # 5 | 22.26 MPa | (227 kgf / cm$^2$) |
| Sample # 6 | 14.71 MPa | (150 kgf / cm$^2$) |
| Sample # 7 | 11.87 MPa | (121 kgf / cm$^2$) |
| Sample # 8 | 12.36 MPa | (126 kgf / cm$^2$) |
| Sample # 9 | 24.52 MPa | (250 kgf / cm$^2$) |
| Sample # 10 | 24.42 MPa | (249 kgf / cm$^2$) |
| Sample # 11 | 22.75 MPa | (232 kgf / cm$^2$) |
| Sample # 12 | 23.24 MPa | (237 kgf / cm$^2$) |
| Average pulling strength = 20.0683 MPa (204.67 kgf / cm$^2$) | | |
| Standard deviation = 5.0779 MPa (51.78 kgf / cm$^2$) | | |

EXAMPLE 2

The substrate samples were identical to the ones of the previous example; steps 1, 2, 3 and 4 of the process were also the same.

5'. The electroless coating was carried out by immersion in a bath comprising equal parts of the following aqueous solutions:

| | |
|---|---|
| hexahydrated nickel sulfate | 26 g / l |
| dihydrated trisodium citrate | 30 g / l |
| hydrated sodium hypophosphite | 17 g / l |
| ammonium sulfate | 66 g / l |

The substrates were immersed for 30 seconds in the bath at 90°C, with pH = 9, then rinsed for 5 to 10 seconds in deionised water ($\rho \approx 3M\Omega cm$).

6'. The substrates were placed in a container filled with distilled water and subjected to 2 minutes ultrasound.

7'. Over the electroless coat of Ni-P, a layer of matte copper was electroplated, by 7 minutes immersion in an acid electroplating bath at ambient temperature, the current density being 3 A / dm$^2$. A commercial bath available from Tecnorevest was used.

8'. Over the copper layer, nickel was electroplated using the bath sold under the tradename Niquel Deweka 720 available from Orwec, at a temperature of 45°C, the current density being 2 A / dm$^2$, followed by rinsing in deionised water.

Four samples were selected for bonding strength testing, using the same technique of the previous example, yielding the following results:

| | | |
|---|---|---|
| Sample # 1 | 15.49 MPa | (158 kgf / cm$^2$) |
| Sample # 2 | 12.96 MPa | (132 kgf / cm$^2$) |
| Sample # 3 | 12.36 MPa | (126 kgf / cm$^2$) |
| Sample # 4 | 12.45 MPa | (127 kgf / cm$^2$) |
| Average pulling strength = 13.3126 MPa (135.75 kgf / cm$^2$) | | |
| Standard deviation = 1.4769 MPa (15.06 kgf / cm$^2$) | | |

## Claims

1.  METHOD FOR THE PREPARATION OF ALUMINA CERAMIC SURFACES FOR ELECTROLESS AND ELECTROCHEMICAL METAL DEPOSITION, comprising:

    • a first cleansing step of the alumina ceramic substrates surface;
    • an etching step for removal of vitreous material from said ceramic substrates surface;
    • a second cleansing step of said substrates surface;
    • sensitisation followed by activation of said substrates surface by means of immersion in aqueous solutions of stannous chloride and palladium chloride;

    **characterised in that** said first surface cleansing step comprises immersion of said substrates in a mixture of sulfuric acid and hydrogen peroxide, said etching step for removal of vitreous material step comprises immersion of said substrates in an aqueous solution of ammonium fluoride and sodium chloride, and said second cleansing step comprises immersion of said substrates in a mixture of sulfuric acid and hydrogen peroxide.

2.  Method as claimed in claim 1, **characterised in that** the mixtures used in said first and second cleansing steps comprise 1 to 4 parts sulfuric acid to 1 part hydrogen peroxide, the temperature of said mixtures being in the range of 90°C to 110°C.

3.  Method as claimed in claims 1 or 2, **characterised in that** the metal deposition comprises the following additional steps:

- electroless deposition, over said activated ceramic surface, of a first coat of nickel with co-deposited boron;
- ultrasound treatment of said substrates immersed in water, for a time period greater than 1 minute;
- electroplating a nickel layer over said electroless nickel-boron first coat, followed by electroplating a layer of copper over said electroplated nickel layer.

4.  Method as claimed in claim 3, **characterised in that** said electroless deposition of nickel and boron is carried out by immersing the substrates, for no longer than 30 seconds, in a bath comprising solutions of nickel chloride, disodium tartrate and dimethyl amine borane.

5.  Method as claimed in claim 4, **characterised in that** said solutions used in said electroless bath comprise the following ranges of concentrations:

| nickel chloride | 11.5 to 13.5 g / l |
| --- | --- |
| disodium tartrate | 46.2 to 48.2 g / l |
| dimethyl amine borane | 1.4 to 2.0 g / l |

6.  Method as claimed in claim 5, **characterised in that** said solutions used in said electroless bath comprise the following concentrations:

| nickel chloride | 12.5 g / l |
| --- | --- |
| disodium tartrate | 47.2 g / l |
| dimethyl amine borane | 1.6 g / l |

7.  Method as claimed in claim 6, **characterised in that** said solutions are combined in the bath in the following proportions:

    6 to 8 parts nickel chloride solution
    6 to 8 parts dimethyl amine borane
    1 part disodium tartrate

8.  Method as claimed in claims 1 or 2, **characterised in that** the metal deposition comprises the following additional steps:

- electroless deposition, over said activated ceramic surface, of a first coat of nickel with co-deposited phosphorus;
- ultrasound treatment of said substrates immersed in water, for a time period greater than 1 minute;
- electroplating a copper layer over said electroless nickel-phosphorus first coat.

9.  Method as claimed in claims 1 or 2, **characterised in that** the electroless deposition of nickel and phosphorus is carried out by immersing the substrates, for a period of time between 30 seconds and 1 minute, in a bath comprising solutions of hexahydrated nickel sulfate, dihydrated trisodium citrate, hydrated sodium hypophosphide and ammonium sulfate.

10. Method as claimed in claim 9, **characterised in that** the bath used in said electroless deposition of nickel and phosphorus comprises the following concentrations of said solutions:

| hexahydrated nickel sulfate | 26 g / l |
| --- | --- |

(continued)

| | |
|---|---|
| dihydrated trisodium citrate | 30 g / l |
| hydrated sodium hypophosphide | 17 g / l |
| ammonium sulfate | 66 g / l |

**11.** Method as claimed in claim 3, **characterised in that** said electroplated nickel layer has a thickness ranging from 0.5 to 2.5 μm (microns).

**12.** Method as claimed in any of the preceding claims, **characterised in that** additional metallic layers are deposited over the electroplated copper layer.

**Patentansprüche**

**1.** VERFAHREN ZUR PRÄPARATION VON KERAMISCHEN ALUMINIUM-OXIDOBERFLÄCHEN FÜR STROMLOSE UND ELEKTROCHEMISCHE METALLABSCHEIDUNG, enthaltend:

- einen ersten Reinigungsschritt der keramischen Aluminiumoxidsubstratoberfläche,
- einen Ätzschritt zum Entfernen von glasartigem Material von der Keramiksubstratoberfläche,
- einen zweiten Reinigungsschritt der Substratoberfläche,
- Sensibilisierung gefolgt von Aktivierung der Substratoberfläche mittels Eintauchens in wässerige Lösungen von Zinnchlorid und Palladiumchlorid,

**dadurch gekennzeichnet**, daß der erste Oberflächenreinigungsschritt ein Tauchen der Substrate in eine Mischung von Schwefelsäure und Wasserstoffperoxid enthält, der Ätzschritt als Entfernungsschritt von glasartigem Material ein Tauchen der Substrate in eine wässerige Lösung von Ammoniumfluorid und Natriumchlorid enthält, und der zweite Reinigungsschritt ein Tauchen der Substrate in eine Mischung von Schwefelsäure und Wasserstoffperoxid enthält.

**2.** Verfahren nach Anspruch 1, **dadurch gekennzeichnet**, daß die Mischungen, die in den ersten und zweiten Reinigungsschritten verwendet werden, 1 bis 4 Teile Schwefelsäure zu 1 Teil Wasserstoffperoxid enthalten, wobei die Temperatur der Mischungen in dem Bereich von 90°C bis 110°C ist.

**3.** Verfahren, nach Anspruch 1 oder 2, **dadurch gekennzeichnet**, daß die Metallabscheidung die folgenden zusätzlichen Schritte enthält:

- stromlose Abscheidung einer ersten Schicht aus Nickel mit mitabgeschiedenem Bor über der aktivierten Kermamikoberfläche,
- Ultraschallbehandlung der Substrate, die in Wasser eingetaucht sind, für eine Zeitperiode größer als 1 Minute,
- Elektroplattieren einer Nickelschicht über der stromlosen ersten Nickel-Bor-Schicht, gefolgt durch Elektroplattieren einer Schicht aus Kupfer über der elektroplattierten Nickelschicht.

**4.** Verfahren nach Anspruch 3, **dadurch gekennzeichnet**, daß die stromlose Abscheidung von Nickel und Bor ausgeführt wird durch Tauchen der Substrate für nicht länger als 30 Sekunden in ein Bad, das Lösungen von Nikkelchlorid, Dinatriumtartrat und Dimethylaminboran enthält.

**5.** Verfahren nach Anspruch 4, **dadurch gekennzeichnet**, daß die Lösungen, die in dem stromlosen Bad verwendet werden, die folgenden Konzentrationsbereiche enthalten:

| | |
|---|---|
| Nickelchlorid | 11,5 bis 13,5 g/l |
| Dinatriumtartrat | 46,2 bis 48,2 g/l |
| Dimethylaminboran | 1,4 bis 2,0 g/l |

**6.** Verfahren nach Anspruch 5, **dadurch gekennzeichnet**, daß die Lösungen, die in dem stromlosen Bad verwendet werden, die folgenden Konzentrationsbereiche enthalten;

| Nickelchlorid | 12,5 g/l |
|---|---|
| Dinatriumtartrat | 47,2 g/l |
| Dimethylaminboran | 1,6 g/l |

**7.** Verfahren nach Anspruch 6, **dadurch gekennzeichnet**, daß die Lösungen in dem Bad in den folgenden Proportionen kombiniert sind:

6 bis 8 Teile Nickelchloridlösung
6 bis 8 Teile Dimethylaminboran
1 Teil Dinatriumtartrat

**8.** Verfahren nach Anspruch 1 oder 2, **dadurch gekennzeichnet**, daß die Metallabscheidung die folgenden zusätzlichen Schritte enthält:

- stromlose Abscheidung einer ersten Schicht aus Nickel mit mitabgeschiedenem Phosphor über der aktivierten Kermamikoberfläche,
- Ultraschallbehandlung der Substrate, die in Wasser eingetaucht sind, für eine Zeitperiode größer als 1 Minute,
- Elektroplattieren einer Kupferschicht über die erste stromlose Nickel-Phosphor-Schicht.

**9.** Verfahren nach Anspruch 1 oder 2, **dadurch gekennzeichnet**, daß die stromlose Abscheidung von Nickel und Phosphor ausgeführt wird durch Tauchen der Substrate für eine Zeitperiode zwischen 30 Sekunden und 1 Minute in ein Bad, enthaltend Lösungen von hexahydriertem Nickelsulfat, dihydriertem Trinatriumcitrat, hydriertem Natriumhypophosphid und Ammoniumsulfat.

**10.** Verfahren nach Anspruch 9, **dadurch gekennzeichnet**, daß das Bad, das bei der stromlosen Abscheidung von Nickel und Phosphor verwendet wird, die folgenden Konzentration der Lösungen enthält:

| hexahydriertes Nickelsulfat | 26 g/l |
|---|---|
| dihydriertes Trinatriumcitrat | 20 g/l |
| hydriertes Natriumhypophosphid | 17 g/l |
| Ammoniumsulfat | 66 g/l |

**11.** Verfahren nach Anspruch 3, **dadurch gekennzeichnet**, daß die elektroplattierte Nickelschicht eine Dicke hat, die von 0,5 bis 2,5 μm (Micron) reicht.

**12.** Verfahren nach jeglichem der vorhergehenden Ansprüche, **dadurch gekennzeichnet**, daß zusätzliche metallische Schichten über der elektroplattierten Kupferschicht abgeschieden werden.

**Revendications**

**1.** Procédé pour la préparation de surfaces céramiques en alumine pour un dépôt sans courant et électrochimique de métal comprenant :

- une première étape de nettoyage de la surface des substrats céramiques en alumine;
- une étape de décapage pour éliminer du matériau vitreux de ladite surface des substrats céramiques;
- une seconde étape de nettoyage de ladite surface des substrats;
- une sensibilisation suivie par une activation de ladite surface des substrats au moyen d'une immersion dans des solutions aqueuses de chlorure stanneux et de chlorure de palladium;

caractérisé en ce que ladite première étape de nettoyage de la surface comprend l'immersion desdits substrats dans un mélange d'acide sulfurique et de peroxyde d'hydrogène, ladite étape de décapage pour l'élimination de matériau vitreux comprend l'immersion desdits substrats dans une solution aqueuse de fluorure d'ammonium et de chlorure de sodium et ladite seconde étape de nettoyage comprend l'immersion desdits substrats dans un mélange d'acide sulfurique et de peroxyde d'hydrogène.

2. Procédé selon la revendication 1, caractérisé en ce que les mélanges utilisés dans lesdites première et seconde étapes de nettoyage comprennent de 1 à 4 parties d'acide sulfurique pour 1 partie de peroxyde d'hydrogène, la température desdits mélanges étant dans l'intervalle de 90°C à 110°C.

3. Procédé selon la revendication 1 ou 2, caractérisé en ce que le dépôt de métal comprend les étapes supplémentaires suivantes :

- un dépôt sans courant sur ladite surface céramique activée d'un premier revêtement de nickel avec du bore co-déposé;
- un traitement aux ultrasons desdits substrats immergés dans l'eau sur une durée supérieure à 1 minute.
- un dépôt électrolytique d'une couche de nickel sur ledit premier revêtement sans courant de nickel-bore, suivi par un dépôt électrolytique d'une couche de cuivre sur ladite couche de nickel déposée par électrolyse.

4. Procédé selon la revendication 3, caractérisé en ce que ledit dépôt sans courant de nickel et de bore est réalisé en immergeant les substrats pendant pas plus de 30 secondes dans un bain comprenant des solutions de chlorure de nickel, de tartrate de disodium et de diméthylamineborane.

5. Procédé selon la revendication 4, caractérisée en ce que lesdites solutions utilisées dans ledit bain sans courant comprennent les intervalles de concentration suivants:

| chlorure de nickel de | 11,5 à 13,5 g/l |
|---|---|
| tartrate de disodium de | 46,2 à 48,2 g/l |
| diméthylamineborane de | 1,4 à 2,0 g/l |

6. Procédé selon la revendication 5, caractérisé en ce que lesdites solutions utilisées dans ledit bain sans courant comprennent les concentrations suivantes :

| chlorure de nickel | 12,5 g/l |
|---|---|
| tartrate de disodium | 47,2 g/l |
| diméthylamineborane | 1,6 g/l |

7. Procédé selon la revendication 6, caractérisé en ce que lesdites solutions sont combinées dans le bain dans les proportions suivantes :

de 6 à 8 parties de solution de chlorure de nickel
de 6 à 8 parties de diméthylamineborane
1 partie de tartrate de disodium.

8. Procédé selon la revendication 1 ou 2, caractérisé en ce que le dépôt de métal comprend les étapes supplémentaires suivantes :

- un dépôt sans courant sur ladite surface céramique activée d'un premier revêtement de nickel avec du phosphore co-déposé;
- un traitement aux ultrasons desdits substrats immergés dans l'eau sur une durée supérieure à 1 minute;
- un dépôt électrolytique d'une couche de cuivre sur ledit premier revêtement sans courant de nickel-phosphore.

9. Procédé selon la revendication 1 ou 2, caractérisé en ce que le dépôt sans courant de nickel et de phosphore est réalisé en immergeant les substrats sur une durée comprise entre 30 secondes et 1 minute dans un bain comprenant des solutions de sulfate de nickel hexahydraté, de citrate de trisodium dihydraté, d'hyposphosphite de sodium hydraté et de sulfate d'ammonium.

10. Procédé selon la revendication 9, caractérisé en ce que le bain utilisé dans ledit dépôt sans courant de nickel et de phosphore comprend les concentrations suivantes desdites solutions :

| | |
|---|---|
| sulfate de nickel hexahydraté | 26g/l |
| citrate de trisodium dihydraté | 30g/l |
| hypophosphite de sodium hydraté | 17 g/l |
| sulfate d'ammonium | 66 g/l |

11. Procédé selon la revendication 3, caractérisé en ce que ladite couche de nickel déposée par électrolyse présente une épaisseur comprise entre 0,5 et 2,5 $\mu$m (microns).

12. Procédé selon l'une quelconque des revendications précédentes, caractérisé en ce que des couches métalliques supplémentaires sont déposées sur la couche de cuivre déposée par électrolyse.